# EUROPÄISCHE PATENTSCHRIFT

(11) **EP 3 942 306 B1**
(45) Veröffentlichungstag und Bekanntmachung des Hinweises auf die Patenterteilung: **14.02.2024**
(21) Anmeldenummer: 20712489.2
(22) Anmeldetag: 13.03.2020
(51) Int. Cl.: G01R 19/00, H02M 1/08, H02M 1/00, H02M 1/32, H02M 7/48

(54) **LEISTUNGSTRANSISTORANORDNUNG MIT STROMMESSSCHALTUNG**
POWER TRANSISTOR ARRANGEMENT HAVING A CURRENT MEASURING CIRCUIT
ENSEMBLE TRANSISTOR DE PUISSANCE COMPORTANT UN CIRCUIT DE MESURE DE COURANT

(30) Priorität: 21.03.2019 DE 102019203902
(43) Veröffentlichungstag der Anmeldung: 26.01.2022
(73) Patentinhaber: Robert Bosch GmbH, 70442 Stuttgart (DE)
(72) Erfinder: ERCKERT, Ricardo, 83043 Bad Aibling (DE); STRACHE, Sebastian, 72827 Wannweil (DE); BARNER, Alexander, 72770 Reutlingen (DE); ROSAHL, Thoralf, 72800 Eningen (DE)
(86) Internationale Anmeldenummer: PCT/EP2020/056746
(87) Internationale Veröffentlichungsnummer: WO 2020/187714

(56) Entgegenhaltungen:
- DE-T5-112014 006 358
- US-A1- 2010 019 750
- US-B1- 6 304 472
- ZHIQIANG WANG ET AL: "A fast overcurrent protection scheme for IGBT modules through dynamic fault current evaluation", APPLIED POWER ELECTRONICS CONFERENCE AND EXPOSITION (APEC), 2013 TWENTY-EIGHTH ANNUAL IEEE, IEEE, 17. März 2013 (2013-03-17), Seiten 577-583, XP032410395, DOI: 10.1109/APEC.2013.6520268 ISBN: 978-1-4673-4354-1
- F. STUECKLER ET AL: "CoolMOS(TM) C7 650V Switch in a Kelvin Source Configuration", INFINEON APPLICATION NOTE AN 2013-05 V1.0, 1. Mai 2013 (2013-05-01), Seiten 1-10, XP055575729, United States

## Beschreibung

Die vorliegende Erfindung betrifft eine Leistungstransistoranordnung, umfassend einen Leistungstransistor und eine mit dem Leistungstransistor verbundene Strommessschaltung zur Bestimmung eines Durchgangsstroms durch den Leistungstransistor, wobei der Durchgangsstrom vom Source-Anschluss des Leistungstransistors über mindestens einen Source-Bonddraht geführt ist, und wobei ein erster Mess-Bonddraht zwischen einem ersten Ende des Source-Bonddrahts, das dem Source-Anschluss zugewandt ist, und dem Source-Anschluss angeschlossen ist. Dieser hat gleichzeitig auch die Funktion der Bezugsmasse des Gatetreibers und der Versorgung der Gateansteuerung. Ein zweiter Mess-Bonddraht ist hinter einem zweiten Ende des Source-Bonddrahts, das dem Source-Anschluss abgewandt ist, angeschlossen, und wobei beide Mess-Bonddrähte mit der Strommessschaltung verbunden sind, wobei zusätzlich zu dem ersten und dem zweiten Mess-Bonddraht ein dritter Mess-Bonddraht vor dem ersten Ende des Source-Bonddrahts angeschlossen ist, wobei auch der dritte Mess-Bonddraht mit einer Referenzmasse der Strommessschaltung verbunden ist.

### Stand der Technik

In Wechselrichtern zur Ansteuerung von Elektromotoren in der Elektromobilität ist es bekannt, für das Erkennen von Überlast den Durchgangsstrom durch den zugehörigen Leistungstransistor zu messen (auch Stromsensierung genannt). Hierfür wird eine Reihe verschiedener Methoden angewendet, wie zum Beispiel DESAT-Erkennung, Integration der Spannung über die Source-Induktivität (eines Source-Bonddrahts) oder auch ein sogenannter SENSE-Emitter-Ausgang bei IGBT (englisch: insulated-gate bipolar transistor) beziehungsweise SENSE-FET bei MOSFET (Metall-Oxid-Halbleiter-Feldeffekttransistor).

Die Anforderungen an die Sicherheitsabschaltungen für derartige Leistungstransistoren werden durch neue schnelle Leistungshalbleiter-Technologien, wie beispielsweise Silizium-Carbid(SiC)- und Gallium-Nitrid(GaN)-Transistoren, immer kritischer. Im Rahmen der Sicherheitsanforderungen werden außerdem redundante Konzepte bevorzugt.

Aktuell wird hauptsächlich die DESAT(Desaturierungs)-Erkennung eingesetzt. Diese ist bei IGBT-Systemen sehr einfach umzusetzen. Außerdem sind IGBT typischerweise bis zu 10 µs kurzschlusssicher, sodass die zeitlichen Anforderungen an die Überstromdetektion geringer sind, als es bei den neueren SiC- und GaN-Technologien der Fall ist. Durch die externe Beschaltung mit Hochvoltdioden zur Entkopplung bei der DESAT-Erkennung muss eine zusätzliche Ausblendzeit eingeführt werden, damit keine fehlerhafte Erkennung stattfindet.

Als Alternative wird der SENSE-FET eingesetzt, also ein Teil des Leistungshalbleiters, der zur Messung des Durchgangsstroms verwendet wird. Dieser Ansatz hat den Nachteil, dass es ein spezielles Layout des Leistungshalbleiters geben muss. Auch ist die Dynamik eingeschränkt und die höheren Kosten im Vergleich mit konventionellen Leistungshalbleitern machen diesen Ansatz daher eher uninteressant.

Der Ansatz der Integration der Spannung über einen Source-Bonddraht ist für hohe Stromänderungen sehr schnell und hinreichend genau. Die sich daraus ergebenen Messsignale sind sehr groß und damit gut auswertbar. In getakteten DC/DC-Wandlern wird diese Methode ebenfalls zur Stromsensierung eingesetzt und ist unter dem Stichwort "DCR-Sensing" in der Literatur zu finden.

Es wird aber auch alternativ zum Beispiel die Gateladung gemessen und diese zur Überstrombewertung herangezogen. Letzteres ist aus T. Horiguchi and H. Akagi, "A high-speed protection circuit for igbts subjected to hard-switching faults", IEEE Transactions on Industry Applications, Ausgabe 51, Nr. 2, ff. 1774-1781, März 2015 (im Folgenden: Horiguchi et al.) sowie aus K. Oberdieck, S. Soenke und R. W. DeDoncker, "Short Circuit Detection Using the Gate Charge Characteristic for Trench/Fieldstop-IGBTs", 18th European Conference on Power Electronics and Applications (EPE'16 ECCE Europe), September 2016 (im Folgenden: Oberdieck et al.) bekannt. Dieser Ansatz ist kosteneffizient und mit geringem Aufwand durchführbar, und es kann damit sehr schnell ein Überstrom detektiert werden. Es werden, wie auch bei dem Ansatz der Messung der Spannung über der Source-Induktivität, keine hochvoltkritischen Knoten erfasst. Durch die Ansteuerung der MOSFET mit Spannungsquellen wird ein Vorwiderstand in der Ausführung benötigt, worüber sich die Gateladung messen lässt. Bei stromquellenbasierten Gate-Treiberschaltungen wird ein externer Gatewiderstand nicht mehr benötigt. Dadurch wird die Messung der Gateladung schwieriger, weil ein zusätzlicher Shunt benötigt wird, der Verluste generiert, nur kleine Signale erzeugt und Einfluss auf die Ansteuerung hat.

Aus US 2010/019750 A1 ist eine Leistungstransistoranordnung der eingangs genannten Art zur Bestimmung eines Durchgangsstroms durch den Leistungstransistor bekannt. Weitere Leistungstransistoranordnungen mit einer Stromsensierungsfunktionalität sind aus US 6 304 472 B1, aus Zhiqiang Wang et al: "A fast overcurrent protection scheme for IGBT modules through dynamic fault current evaluation", Applied Power Electronics Conference And Exposition (APEC), 2013 twenty-eight annual IEEE, IEEE, 17. März 2013 (2013-03-17), Seiten 577-583, aus DE 11 2014 006358 T5 sowie aus F. Stueckler et al :"CoolMOS(TM) C7 650V Switch in a Kelvin Source Configuration", Infinieon Application Note AN 2013-05 V1 .0, 1. Mai 2013 (2013-05-01), Seiten 1-10 bekannt.

### Offenbarung der Erfindung

Erfindungsgemäß wird ein Leistungstransistor der eingangs genannten Art zur Verfügung gestellt, wobei die Strommessschaltung einen Differenzverstärker umfasst, um eine Spannungsdifferenz zwischen beiden Enden des Source-Bonddrahts aus den von den Mess-Bonddrähten erhaltenen Spannungen zu bestimmen und dadurch den Durchgangsstrom durch den Leistungstransistor zu bestimmen, wobei ein erster Spannungspfad des ersten Bond-Messdrahts zwischen dem ersten Ende des Source-Bonddrahts und der Strommessschaltung und ein zweiter Spannungspfad des zweiten Bond-Messdrahts zwischen dem zweiten Ende des Source-Bonddrahts und der Strommessschaltung über einen Integrator verbunden sind, wobei der erste Spannungspfad mit einem dritten Spannungspfad des dritten Bond-Messdrahts, der zwischen dem zweiten Ende des Source-Bonddrahts und der Strommessschaltung verläuft, vor dem Differenzverstärker zusammengeführt ist, um einen gemeinsamen ersten Signaleingang für den Differenzverstärker zu liefern, und wobei der zweite Spannungspfad einen zweiten Signaleingang für den Differenzverstärker liefert, sodass die Strommessschaltung durch die Kombination der zwei Signale von den drei Spannungspfaden der drei Mess-Bonddrähte dazu eingerichtet ist, sowohl den Durchgangsstrom durch den Leistungstransistor als auch die Gateladung während eines Schaltungsvorgangs des Leistungstransistors zu bestimmen.

### Vorteile der Erfindung

Es wird mit dieser Lösung eine Leistungstransistoranordnung bereitgestellt, die eine Messung der Gateladung in einer Kombination aus der Source-Induktivitätsmessung und einer parallelen Source-Induktivitätsmessung ohne Gateladungsfehler ermöglicht. Durch beide Messungen kann eine Differenz gebildet werden, mit der die Gateladung bestimmt werden kann. Dadurch kann dynamisches Messen der Gateladung in stromquellenbasierenden Gate-Treiberschaltungen ohne Nachteile, wie es bei stromquellenbasierten Gate-Treiberschaltungen mit einem zusätzlichen Shunt der Fall wäre, realisiert werden. Der zusätzliche Aufwand für die Erfassung der Gateladung ist gering und lässt sich beispielsweise sehr einfach in einem ASIC integrieren.

Durch den neuen Ansatz der Gateladungs-Messung bei stromquellenbasierenden Gate-Treiberschaltungen wird durch minimalen Zusatzaufwand (zweiter Bond) eine zweite dynamische Überstromdetektion möglich.

Durch redundante Messung der Spannung an der Source-Induktivität kann gleichzeitig sowohl der direkte Stromwert im Leistungspfad als auch die Gateladung, die zum Einschalten des Leistungstransistors benötigt wird, gemessen werden. Im Gegensatz zu dem Ansatz in Horiguchi et al. beziehungsweise Oberdieck et al. kann dies auch ohne externen Shunt erfolgen und damit auch Einsatz in Gate-Treiberschaltungen mit Stromquellenprinzip finden. Durch die Bewertung der Gateladung können verschiedene Kriterien bewertet werden. Es kann ein Überstrom detektiert werden beziehungsweise Charakterisierungsmessungen vorgenommen werden. Dies kann hierbei auch unabhängig von der Ansteuerung erfolgen. Im Vergleich mit Gate-Treiberschaltungen mit Stromquellenprinzip müssen die Vorwiderstände bei spannungsquellenbasierten Gate-Treiberschaltungen je nach Arbeitspunkt unterschiedlich ausgelegt werden. Die Auswerteschaltung basierend auf Shunt (Horiguchi et al. beziehungsweise Oberdieck et al.) muss dabei immer wieder neu angepasst werden.

Der zweite Bond-Messdraht kann sich vom dritten Bond-Messdraht beispielsweise dadurch unterscheiden, dass der zweite Bond-Messdraht über einen Integrator mit dem ersten Bond-Messdraht gekoppelt ist. Der Integrator ist dabei vorzugsweise ein Widerstand-Kondensator-Netzwerk (RC-Netzwerk).

Die Strommessschaltung umfasst einen Differenzverstärker, um eine Spannungsdifferenz zwischen beiden Enden des Source-Bonddrahts aus den von den Mess-Bonddrähten erhaltenen Spannungen zu bestimmen und dadurch den Durchgangsstrom durch den Leistungstransistor zu bestimmen. Der Durchgangsstrom kann durch Integration berechnet werden. Zusätzlich zu einer genauen Bestimmung des Durchgangsstroms, kann durch die Einbeziehung des dritten Mess-Bonddrahts zusätzlich die Gateladung bestimmt werden und damit eine redundantere Überstromsicherung erreicht werden.

Ein erster Spannungspfad des ersten Bond-Messdrahts zwischen dem ersten Ende des Source-Bonddrahts und der Strommessschaltung und ein zweiter Spannungspfad des zweiten Bond-Messdrahts zwischen dem zweiten Ende des Source-Bonddrahts und der Strommessschaltung sind über einen Integrator verbunden. Der Integrator ist dabei vorzugsweise ein Widerstand-Kondensator-Netzwerk (RC-Netzwerk). Somit lässt sich die Spannungsdifferenz über den Source-Bonddraht durch die Strommessschaltung bestimmen.

Der zweite Spannungspfad liefert einen zweiten Signaleingang für den Differenzverstärker. Durch die Kombination der zwei Signale von den drei Spannungspfaden der drei Mess-Bonddrähte kann dann sowohl der Durchgangsstrom als auch die Gateladung genau bestimmt werden. Der Arbeitspunkt kann somit bewertet werden und eine zuverlässigere Sicherheitsabschaltung im Kurzschlussfall erreicht werden.

In einer bevorzugten Ausführungsform umfasst die Leistungstransistoranordnung eine Gate-Treiberschaltung zur Ansteuerung eines Gate-Anschlusses des Leistungstransistors, wobei der erste und zweite Mess-Bonddraht durch den dritten Mess-Bonddraht von der Gate-Treiberschaltung entkoppelt ist. Mit einem zusätzlichen Mess-Bonddraht, der die Gate-Treiberschaltung von der Strommessschaltung entkoppelt, kann der Durchgangsstrom durch den Leistungstransistor sehr gut gemessen werden. Durch den Ansatz, beide Integrationen durchzuführen, ergibt sich eine Differenz, die den Fehler durch den Gate-Ladepfad wiedergibt und genau der Gateladung entspricht. Durch diese Differenzmessung lässt sich die Gateladung bei jedem Schaltvorgang zusätzlich bestimmen und es kann eine Bewertung des Arbeitspunkts stattfinden und im Kurzschlussfall eine Sicherheitsabschaltung durchgeführt werden. Außerdem kann bei Leistungstransistoranordnungen mit parallel geschalteten Leistungshalbleitern erkannt werden, wenn einzelne Bauelemente ausfallen beziehungsweise nicht mehr eingeschaltet werden. Dies kann zum Beispiel bei Bondabriss oder Delamination der Fall sein.

Es ist bevorzugt, wenn die Strommessschaltung dazu eingerichtet ist, den Ausgang des Differenzverstärkers durch analoge und/oder digitale Auswertung weiterzuverarbeiten. Diese Funktionalität kann beispielsweise in einem ASIC der Strommessschaltung integriert sein.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 eine Leistungstransistoranordnung des Standes der Technik,
Figur 2 eine weitere Leistungstransistoranordnung, und
Figur 3 eine Ausführungsform einer erfindungsgemäßen Leistungstransistoranordnung.

### Ausführungsformen der Erfindung

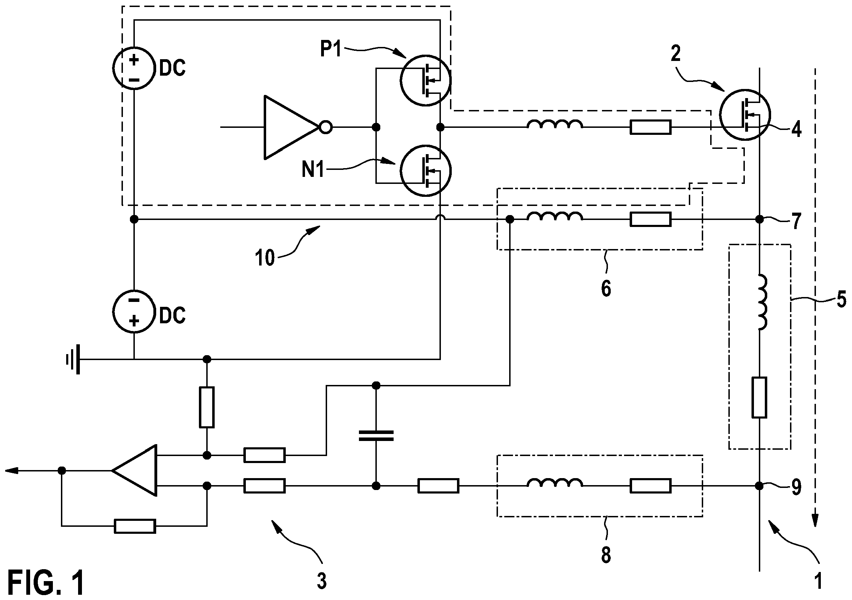

In Figur 1 ist eine Leistungstransistoranordnung 1 des Standes der Technik dargestellt. Die Leistungstransistoranordnung 1 umfasst einen Leistungstransistor 2 und eine mit dem Leistungstransistor verbundene Strommessschaltung 3 zur Bestimmung eines Durchgangsstroms durch den Leistungstransistor 1. Der Durchgangsstrom (durch einen gestrichelten Pfeil von oben nach unten angedeutet) ist vom Source-Anschluss 4 des Leistungstransistors 2 über mindestens einen Source-Bonddraht 5 geführt.

Ein erster Mess-Bonddraht 6 ist zwischen einem ersten Ende 7 des Source-Bonddrahts 5, das dem Source-Anschluss 4 zugewandt ist, und dem Source-Anschluss 4 angeschlossen. Ein zweiter Mess-Bonddraht 8 ist hinter einem zweiten Ende 9 des Source-Bonddrahts 5, das dem Source-Anschluss 4 abgewandt ist, angeschlossen. Beide Mess-Bonddrähte 6, 8 sind mit der Strommessschaltung 3 verbunden, wobei der erste Mess-Bonddraht 6 über eine Gate-Treiberschaltung 10 mit der Strommessschaltung 3 verbunden ist.

In Figur 1 ist der klassische Ansatz zu sehen, mit dem der Durchgangsstrom (beziehungsweise ein Überstrom) bei Leistungshalbleitern mittels der Induktivität des Source-Bonddrahts detektiert wird. Mit einer gestrichelten Schleife ist der Gate-Ladepfad nachverfolgt. Treibertransistoren P1 und N1 der Gate-Treiberschaltung 10 bilden hier den Treiber für den Gate-Ladepfad zum Ansteuern des Leistungstransistors 2. Die Strommessschaltung 3 rechts wird für die Auswertung und Signalanpassung benötigt. Der Source-Bonddraht 5 umfasst parasitäre Elemente (für alle Bonddrähte in den Figuren als Widerstand und Induktivität in Reihe dargestellt), die für die Durchgangsstrom-Messung genutzt werden. Der Bezugspunkt wird über den ersten Mess-Bonddraht 6 hergestellt. Die Strommessschaltung 3 erfasst die Spannung, die über den Source-Bonddraht 5 abfällt. Durch die Beschaltung mit dem zweiten Mess-Bonddraht 8 wird diese Spannung integriert und bildet damit den Strom durch den Source-Bonddraht 5 ab.

Die Erfassung der Spannung über den Source-Bonddraht 5 muss mit dem Einschalten des Leistungshalbleiters gestartet werden. Aufgrund der Schaltungsanordnung wird mit dem Einschalten des Leistungstransistors über den ersten Mess-Bonddraht 6 zusätzlich noch der Strom des Gate-Ladepfades (gestrichelte Schleife) integriert. Hierbei ist zu beachten, dass die Induktivität im Verhältnis zum Leistungspfad über den Source-Bonddraht 5 deutlich größer ist und damit der Fehler im Verhältnis von Induktivität/ Widerstand des ersten Mess-Bonddrahts 6 vergrößert wird. Dadurch ergibt sich ein Messfehler bei diesem bekannten Schaltungstyp.

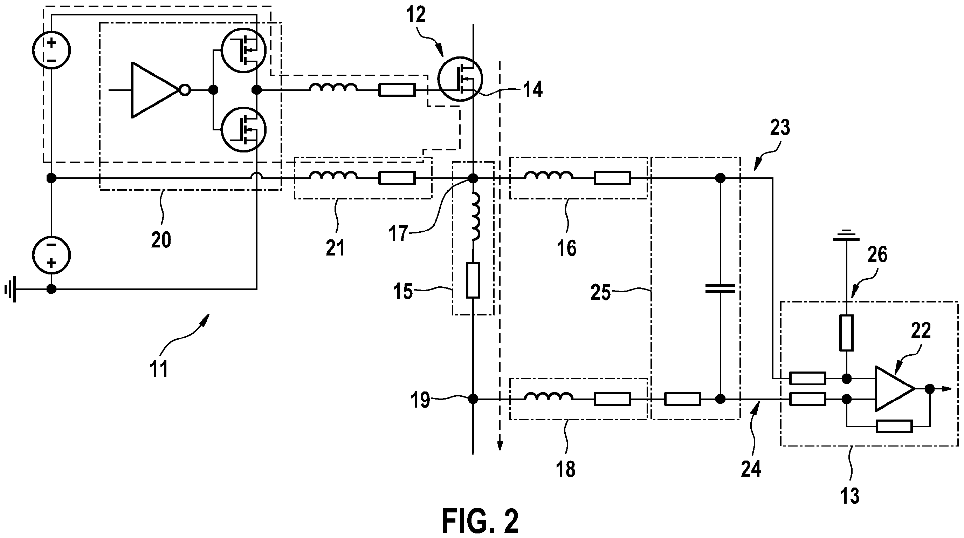

Figur 2 zeigt ein Beispiel einer Leistungstransistoranordnung 11. Die Leistungstransistoranordnung 11 umfasst einen Leistungstransistor 12 und eine mit dem Leistungstransistor verbundene Strommessschaltung 13 zur Bestimmung eines Durchgangsstroms durch den Leistungstransistor 12. Der Durchgangsstrom ist vom Source-Anschluss 14 des Leistungstransistors 12 über mindestens einen Source-Bonddraht 15 geführt.

Ein erster Mess-Bonddraht 16 ist zwischen einem ersten Ende 17 des Source-Bonddrahts 15, das dem Source-Anschluss 14 zugewandt ist, und dem Source-Anschluss 14 angeschlossen. Ein zweiter Mess-Bonddraht 18 ist hinter einem zweiten Ende 19 des Source-Bonddrahts 15, das dem Source-Anschluss 14 abgewandt ist, angeschlossen. Die ersten und zweiten Mess-Bonddrähte 16, 18 sind mit der Strommessschaltung 13 verbunden, wobei beide hier (im Gegensatz zu Figur 1) aber von einer Gate-Treiberschaltung 20 entkoppelt sind.

Zusätzlich zu dem ersten und dem zweiten Mess-Bonddraht 16, 18 ist ein dritter Mess-Bonddraht 21 hinter dem ersten Ende 17 des Source-Bonddrahts 15 angeschlossen, wobei auch der dritte Mess-Bonddraht 21 mit der Strommessschaltung verbunden 13 ist.

Die Strommessschaltung 13 umfasst einen Differenzverstärker 22, um eine Spannungsdifferenz zwischen beiden Enden 17, 19 des Source-Bonddrahts 15 aus den von den Mess-Bonddrähten 16, 18, 21 erhaltenen Spannungen zu bestimmen und dadurch den Durchgangsstrom durch den Leistungstransistor 12 zu bestimmen. Der Durchgangsstrom kann wie zuvor erwähnt durch Integration der Spannungsdifferenz über die Zeit bestimmt werden. Zusätzlich zu einer genauen Bestimmung des Durchgangsstroms, kann durch die Einbeziehung des dritten Mess-Bonddrahts 21 zusätzlich die Gateladung des Gates des Leistungstransistors 12 bestimmt werden und damit eine redundantere Überspannungssicherung erreicht werden.

Ein erster Spannungspfad 23 des ersten Bond-Messdrahts 16 ist zwischen dem ersten Ende 17 des Source-Bonddrahts 15 und der Strommessschaltung und ein zweiter Spannungspfad 24 des zweiten Bond-Messdrahts 18 ist zwischen dem zweiten Ende des Source-Bonddrahts 15 und der Strommessschaltung 13 über einen Integrator 25 (hier in der Ausführung als RC Netzwerk) verbunden.

Der erste Spannungspfad 23 ist mit einem dritten Spannungspfad 26 des dritten Bond-Messdrahts 21, der zwischen dem zweiten Ende 19 des Source-Bonddrahts 15 und der Strommessschaltung 13 verläuft, vor dem Differenzverstärker 22 zusammengeführt, um einen gemeinsamen ersten Signaleingang für den Differenzverstärker 22 zu liefern.

Der zweite Spannungspfad 24 liefert einen zweiten Signaleingang für den Differenzverstärker 22. Durch die Kombination der beiden Konzepte aus Figur 1 und Figur 2 und die differentielle Auswertung der Signale kann dann sowohl der Durchgangsstrom als auch die Gateladung genau bestimmt werden. Der Arbeitspunkt kann somit bewertet werden und eine zuverlässigere Sicherheitsabschaltung im Kurzschlussfall erreicht werden. Die Strommessschaltung 13 ist dazu eingerichtet, sowohl den Durchgangsstrom durch den Leistungstransistor als auch die Gateladung während eines Schaltungsvorgangs des Leistungstransistors zu bestimmen. Dazu kann in der Leistungstransistoranordnung 11 (beziehungsweise in der Strommessschaltung 13) beispielsweise Auswertungselektronik für eine analoge oder digitale Weiterverarbeitung der Ausgabe des Differenzverstärkers 22 vorgesehen sein.

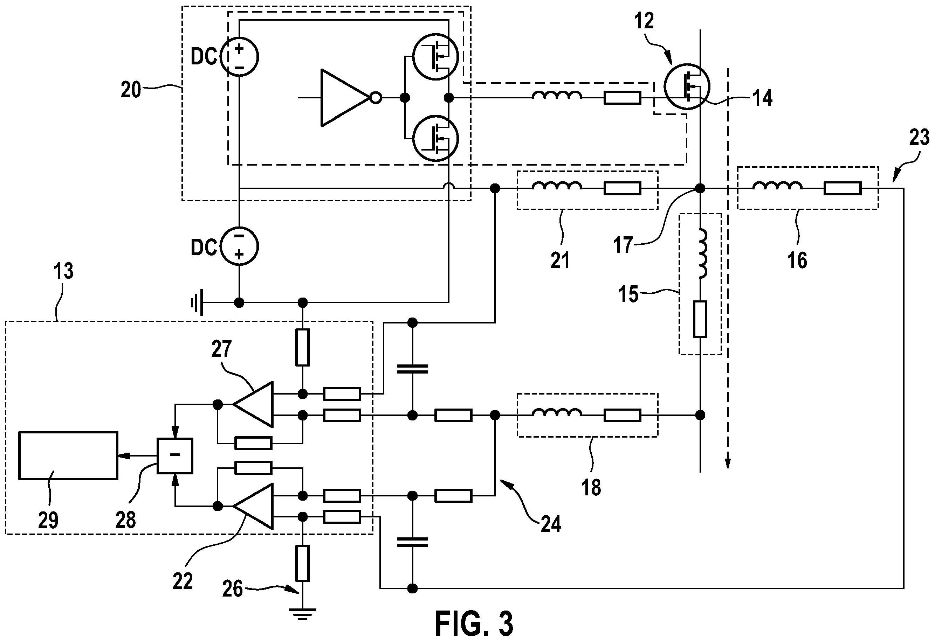

Dies ist in Figur 3 dargestellt, die beide Konzepte der Figuren 1 und 2 kombiniert und eine Ausführungsform einer erfindungsgemäßen Leistungstransistoranordnung zeigt. Es erfolgt mit dieser Lösung also eine Kombination der Stromsensierungen gemäß den Lösungen aus den ersten beiden Ausführungsformen für die erfindungsgemäße Gateladungsmessung. Entsprechende Elemente tragen dieselben Bezugszeichen zu den vorherigen Ausführungsformen. Zusätzlich zum Differenzverstärker 22 liefert ein zweiter Differenzverstärker 27 ein Signal entsprechend dem Aufbau gemäß Figur 1. Diese Signale werden in einem Differenzbildner 28 verglichen und in einer Recheneinheit 29 ausgewertet. So kann durch Integration der Differenz der jeweils gemessen Ströme über die Zeit zusätzlich die Gateladung bestimmt werden.

## Patentansprüche

1. Leistungstransistoranordnung (11), umfassend einen Leistungstransistor (12) und eine mit dem Leistungstransistor (12) verbundene Strommessschaltung (13) zur Bestimmung eines Durchgangsstroms durch den Leistungstransistor (12), wobei der Durchgangsstrom vom Source-Anschluss (14) des Leistungstransistors (12) über mindestens einen Source-Bonddraht (15) geführt ist, und wobei ein erster Mess-Bonddraht (16) zwischen einem ersten Ende (17) des Source-Bonddrahts (15), das dem Source-Anschluss (14) zugewandt ist, und dem Source-Anschluss (14) angeschlossen ist,
und wobei ein zweiter Mess-Bonddraht (18) hinter einem zweiten Ende (19) des Source-Bonddrahts (15), das dem Source-Anschluss (14) abgewandt ist, angeschlossen ist, und wobei beide Mess-Bonddrähte (16, 18) mit der Strommessschaltung (13) verbunden sind, wobei zusätzlich zu dem ersten und dem zweiten Mess-Bonddraht (16, 18) ein dritter Mess-Bonddraht (21) vor dem ersten Ende (17) des Source-Bonddrahts (15) angeschlossen ist, wobei der dritte Mess-Bonddraht (21) mit einer Referenzmasse der Strommessschaltung (13) verbunden ist, **dadurch gekennzeichnet, dass** die Strommessschaltung (13) einen Differenzverstärker (22) umfasst, um eine Spannungsdifferenz zwischen beiden Enden (17, 19) des Source-Bonddrahts (15) aus den von den Mess-Bonddrähten (16, 18, 21) erhaltenen Spannungen zu bestimmen und dadurch den Durchgangsstrom durch den Leistungstransistor (12) zu bestimmen, und wobei ein erster Spannungspfad (23) des ersten Bond-Messdrahts (16) zwischen dem ersten Ende (17) des Source-Bonddrahts (15) und der Strommessschaltung (13) und ein zweiter Spannungspfad (24) des zweiten Bond-Messdrahts (18) zwischen dem zweiten Ende (19) des Source-Bonddrahts (15) und der Strommessschaltung (13) über einen Integrator (25) verbunden sind, wobei der erste Spannungspfad (23) mit einem dritten Spannungspfad (26) des dritten Bond-Messdrahts (21), der zwischen dem zweiten Ende (19) des Source-Bonddrahts (15) und der Strommessschaltung (13) verläuft, vor dem Differenzverstärker (22) zusammengeführt ist, um einen gemeinsamen ersten Signaleingang für den Differenzverstärker (22) zu liefern, und wobei der zweite Spannungspfad (24) einen zweiten Signaleingang für den Differenzverstärker liefert, sodass die Strommessschaltung (13) durch die Kombination der zwei Signale von den drei Spannungspfaden (23, 24, 26) der drei Mess-Bonddrähte (16, 18, 21) dazu eingerichtet ist, sowohl den Durchgangsstrom durch den Leistungstransistor (12) als auch die Gateladung während eines Schaltungsvorgangs des Leistungstransistors (12) zu bestimmen.

2. Leistungstransistoranordnung (11) nach Anspruch 1, umfassend eine Gate-Treiberschaltung (20) zur Ansteuerung eines Gate-Anschlusses des Leistungstransistors (12), wobei der erste und der zweite Mess-Bonddraht (16, 18) durch den dritten Mess-Bonddraht (21) von der Gate-Treiberschaltung (20) entkoppelt ist.

3. Leistungstransistoranordnung (11) nach Anspruch 1 oder 2, wobei die Strommessschaltung (13) dazu eingerichtet ist, den Ausgang des Differenzverstärkers (22) durch analoge und/oder digitale Auswertung weiterzuverarbeiten.

## Claims

1. Power transistor arrangement (11), comprising a power transistor (12) and a current measuring circuit (13) which is connected to the power transistor (12) and is intended to determine a forward current through the power transistor (12), wherein the forward current is guided from the source terminal (14) of the power transistor (12) via at least one source bonding wire (15), and wherein a first measuring bonding wire (16) is connected between a first end (17) of the source bonding wire (15) facing the source terminal (14) and the source terminal (14),
and wherein a second measuring bonding wire (18) is connected downstream of a second end (19) of the source bonding wire (15) facing away from the source terminal (14), and wherein both measuring bonding wires (16, 18) are connected to the current measuring circuit (13), wherein, in addition to the first and second measuring bonding wires (16, 18), a third measuring bonding wire (21) is connected upstream of the first end (17) of the source bonding wire (15), wherein the third measuring bonding wire (21) is connected to a reference earth of the current measuring circuit (13), **characterized in that** the current measuring circuit (13) comprises a differential amplifier (22) in order to determine a voltage difference between both ends (17, 19) of the source bonding wire (15) from the voltages obtained by the measuring bonding wires (16, 18, 21) and thereby to determine the forward current through the power transistor (12), and wherein a first voltage path (23) of the first bonding measuring wire (16) is connected between the first end (17) of the source bonding wire (15) and the current measuring circuit (13) and a second voltage path (24) of the second bonding measuring wire (18) is connected between the second end (19) of the source bonding wire (15) and the current measuring circuit (13) via an integrator (25), wherein the first voltage path (23) is merged upstream of the differential amplifier (22) with a third voltage path (26) of the third bonding measuring wire (21), the third voltage path running between the second end (19) of the source bonding wire (15) and the current measuring circuit (13), in order to provide a common first signal input for the differential amplifier (22), and wherein the second voltage path (24) provides a second signal input for the differential amplifier, such that the current measuring circuit (13) is configured, through the combination of the two signals from the three voltage paths (23, 24, 26) of the three measuring bonding wires (16, 18, 21), to determine both the forward current through the power transistor (12) and the gate charge during a switching process of the power transistor (12).

2. Power transistor arrangement (11) according to Claim 1, comprising a gate driver circuit (20) for actuating a gate terminal of the power transistor (12), wherein the first and second measuring bonding wires (16, 18) are decoupled from the gate driver circuit (20) by the third measuring bonding wire (21).

3. Power transistor arrangement (11) according to Claim 1 or 2, wherein the current measuring circuit (13) is configured to further process the output of the differential amplifier (22) through analogue and/or digital evaluation.

## Revendications

1. Arrangement de transistor de puissance (11), comprenant un transistor de puissance (12) et un circuit de mesure de courant (13) connecté au transistor de puissance (12) pour déterminer un courant de passage à travers le transistor de puissance (12), le courant de passage étant conduit depuis la borne de source (14) du transistor de puissance (12) par le biais d'au moins un fil de liaison de source (15), et un premier fil de liaison de mesure (16) étant raccordé entre une première extrémité (17) du fil de liaison de source (15), qui est dirigée vers la borne de source (14), et la borne de source (14),
et un deuxième fil de liaison de mesure (18) étant raccordé derrière une deuxième extrémité (19) du fil de liaison de source (15), qui est orientée à l'opposé de la borne de source (14), et les deux fils de liaison de mesure (16, 18) étant connectés au circuit de mesure de courant (13), un troisième fil de liaison de mesure (21) étant raccordé avant la première extrémité (17) du fil de liaison de source (15) en plus du premier et du deuxième fil de liaison de mesure (16, 18), le troisième fil de liaison de mesure (21) étant connecté à une masse de référence du circuit de mesure de courant (13), **caractérisé en ce que** le circuit de mesure de courant (13) comprend un amplificateur différentiel (22) afin de déterminer une différence de tension entre les deux extrémités (17, 19) du fil de liaison de source (15) à partir des tensions obtenues par les fils de liaison de mesure (16, 18, 21) et ainsi déterminer le courant de passage à travers le transistor de puissance (12), et un premier chemin de tension (23) du premier fil de mesure de liaison (16) entre la première extrémité (17) du fil de liaison de source (15) et le circuit de mesure de courant (13) et un deuxième chemin de tension (24) du deuxième fil de mesure de liaison (18) entre la deuxième extrémité (19) du fil de liaison de source (15) et le circuit de mesure de courant (13) étant connectés par le biais d'un intégrateur (25), le premier chemin de tension (23) étant, avant l'amplificateur différentiel (22), fusionné avec un troisième chemin de tension (26) du troisième fil de mesure de liaison (21), lequel suit un tracé entre la deuxième extrémité (19) du fil de liaison de source (15) et le circuit de mesure (13), afin de fournir une première entrée de signal commune pour l'amplificateur différentiel (22), et le deuxième chemin de tension (24) fournissant une deuxième entrée de signal pour l'amplificateur différentiel, de sorte que le circuit de mesure de courant (13) est conçu, par la combinaison des deux signaux provenant des trois chemins de tension (23, 24, 26) des trois fils de liaison de mesure (16, 18, 21), pour déterminer aussi bien le courant de passage à travers le transistor de puissance (12) que la charge de grille pendant une opération de commutation du transistor de puissance (12).

2. Arrangement de transistor de puissance (11) selon la revendication 1, comprenant un circuit de commande de grille (20) destiné à commander une borne de grille du transistor de puissance (12), le premier et le deuxième fil de liaison de mesure (16, 18) étant découplés du circuit de commande de grille (20) par le troisième fil de liaison de mesure (21).

3. Arrangement de transistor de puissance (11) selon la revendication 1 ou 2, le circuit de mesure de courant (13) étant conçu pour effectuer un traitement ultérieur sur la sortie de l'amplificateur différentiel (22) par interprétation analogique et/ou numérique.
